# EUROPÄISCHE PATENTANMELDUNG

(11) **EP 3 839 670 A1**
(43) Veröffentlichungstag der Anmeldung: **23.06.2021**
(21) Anmeldenummer: 19217653.5
(22) Anmeldetag: 18.12.2019
(51) Int. Cl.: G05B 19/042, G06F 9/445

(54) **VERFAHREN ZUM STEUERN VON FUNKTIONSELEMENTEN UND VORRICHTUNG ZUR ANWENDUNG IN DER BIOPROZESSTECHNIK UND/ODER IN DER MEDIZINTECHNIK**

(71) Anmelder: Eppendorf AG, 22339 Hamburg (DE)
(72) Erfinder: Streule, Wolfgang, 52445 Titz-Rödingen (DE); Ertel Guido, 41539 Dormagen (DE)
(74) Vertreter: Eisenführ Speiser

(57) **Zusammenfassung**

Die Erfindung betrifft ein Verfahren zum Steuern von Funktionselementen in der Bioprozesstechnik und/oder in der Medizintechnik und eine Vorrichtung zur Anwendung in der Bioprozesstechnik und/oder in der Medizintechnik. Das Verfahren umfasst: Bereitstellen eines ersten Funktionselements, das einen Speicher aufweist, in dem Elementinformationen gespeichert sind und die Elementinformationen Angaben über die Art und die Funktion des Funktionselements umfassen, Bereitstellen eines zweiten Funktionselements, Anschließen des ersten und des zweiten Funktionselements an eine Steuereinheit, Auslesen der Elementinformationen aus dem ersten Funktionselement, Durchführen einer Prüfung der ausgelesenen Elementinformationen mit Elementinformationen, die von dem zweiten Funktionselement ausgelesen sind und/oder mit Informationen, die in der Steuereinheit gespeichert sind, Steuern des ersten Funktionselements mittels der Steuereinheit in Abhängigkeit der Prüfung und/oder in Abhängigkeit der Elementinformationen, Speichern von Prozessinformationen in dem Speicher des ersten Funktionselements.

## Beschreibung

Die Erfindung betrifft ein Verfahren zum Steuern von Funktionselementen in der Bioprozesstechnik und/oder in der Medizintechnik und eine Vorrichtung zur Anwendung in der Bioprozesstechnik und/oder in der Medizintechnik.

In der Bioprozesstechnik und in der Medizintechnik kommen häufig verschiedene Funktionselemente in komplexen Prozessen zum Einsatz. Dabei ist die Prozesssicherheit gerade in diesen Anwendungsgebieten von besonderer Bedeutung, insbesondere die Sicherheit der Anwender und/oder Patienten, die Reproduzierbarkeit des Prozesses und/oder das Prozessergebnis insgesamt. Prozesse in der Bioprozesstechnik und/oder in der Medizintechnik finden meist in regulierten Umgebungen statt, wobei insbesondere auch Richtlinien zur Qualitätssicherung der Prozessabläufe und der Prozessumgebung einzuhalten sind, was auch als gute Herstellungspraxis (Good Manufacturing Practice, GMP) bezeichnet wird.

Die Anforderungen des GMP gerade an komplexe Prozesse und Prozessumgebungen sind hoch und stellen in der Praxis bei der Umsetzung einen nicht unerheblichen Aufwand dar.

Es ist daher eine Aufgabe der vorliegenden Erfindung, ein verbessertes Verfahren zum Steuern von Funktionselementen und eine verbesserte Vorrichtung zur Anwendung in der Bioprozesstechnik und/oder in der Medizintechnik bereitzustellen. Ferner ist es eine Aufgabe der vorliegenden Erfindung, ein Verfahren zum Steuern von Funktionselementen und eine Vorrichtung zur Anwendung in der Bioprozesstechnik und/oder in der Medizintechnik bereitzustellen, welche die Prozesssicherheit erhöhen und/oder die Einhaltung von Qualitätsrichtlinien wie GMP erleichtern und hierfür vorzugsweise effiziente und/oder kostengünstige Lösungen bereitstellen.

Diese Aufgabe wird erfindungsgemäß gelöst durch ein Verfahren zum Steuern von Funktionselementen in der Bioprozesstechnik und/oder in der Medizintechnik, umfassend: Bereitstellen eines ersten Funktionselements, das einen Speicher aufweist, in dem Elementinformationen gespeichert sind und die Elementinformationen Angaben über die Art und die Funktion des ersten Funktionselements umfassen, Bereitstellen eines zweiten Funktionselements, Anschließen des ersten und des zweiten Funktionselements an eine Steuereinheit, Auslesen der Elementinformationen aus dem ersten Funktionselement, Durchführen einer Prüfung der ausgelesenen Elementinformationen des ersten Funktionselements mit Elementinformationen, die von dem zweiten Funktionselement ausgelesen sind und/oder mit Informationen, die in der Steuereinheit gespeichert sind, Steuern mindestens eines des ersten und des zweiten Funktionselements in Abhängigkeit der Prüfung und/oder in Abhängigkeit der Elementinformationen, Speichern von Prozessinformationen in dem Speicher des ersten Funktionselements.

Beim hier beschriebenen Verfahren werden ein erstes und ein zweites Funktionselement sowie eine Steuereinheit bereitgestellt und die Funktionselemente an diese Steuereinheit angeschlossen. Das Anschließen der Funktionselemente kann kabelgebunden oder kabellos erfolgen. Das erste Funktionselement weist einen Speicher auf, in dem Elementinformationen zu diesem ersten Funktionselement gespeichert sind.

Wie im Folgenden noch näher beschrieben wird, kann auch das zweite Funktionselement einen Speicher aufweisen, in dem Elementinformationen zu dem zweiten Funktionselement gespeichert sind. Die Elementinformationen des jeweiligen Funktionselements enthalten Angaben über die Art und die Funktion des jeweiligen Funktionselements.

Die Elementinformationen aus dem ersten Funktionselement werden von der Steuereinheit ausgelesen. Auch das Auslesen kann kabelgebunden oder kabellos erfolgen.

Gemäß dem hier beschriebenen Verfahren wird, beispielsweise in der Steuereinheit oder in einer, mit der Steuereinheit vorzugsweise kabelgebunden oder kabellos verbundenen Auswerteeinheit, eine Prüfung der ausgelesenen Elementinformationen des ersten Funktionselements mit Elementinformationen, die von dem zweiten Funktionselement ausgelesen sind und/oder mit Informationen, die in der Steuereinheit gespeichert sind, durchgeführt. Hierbei können somit insbesondere die Angaben über die Art und Funktion des ersten Funktionselements abgeglichen werden mit der Art und Funktion des zweiten Funktionselements oder mit anderen Angaben, die für die erfolgreiche Durchführung eines Prozesses erforderlich oder hilfreich sind. Diese Informationen können aus dem zweiten Funktionselement ausgelesene Elementinformationen sein und/oder Informationen sein, die in der Steuereinheit gespeichert sind.

Ein Ergebnis der Prüfung kann beispielsweise sein, dass bestimmte Funktionselemente nicht oder nur unter bestimmten Bedingungen miteinander kompatibel sind. Ein weiteres Beispiel für ein Ergebnis einer Prüfung ist, dass ein Funktionselement für einen geplanten Prozess nicht verwendbar ist. In solchen Fällen würde vorzugsweise auch keine Steuerung dieser nicht kompatiblen bzw. nicht verwendbaren Funktionselemente erfolgen. In solchen Fällen kann beispielsweise eine Warnmeldung generiert und ausgegeben werden, die auf die mangelnde Kompatibilität bzw. Verwendbarkeit beziehungsweise deren Kombinationen hinweist. Ein weiteres Beispiel für ein Ergebnis der Prüfung ist, dass bestimmte Funktionselemente Beziehung Weise deren Kombinationen nur unter bestimmten Bedingungen miteinander kompatibel sind und/oder nur in bestimmten Prozessvarianten verwendbar sind. Ein solches Ergebnis der Prüfung kann dann vorzugsweise beim Steuern der jeweiligen Funktionselemente berücksichtigt werden, sodass sichergestellt ist, dass das jeweilige Funktionselement nur im kompatiblen Bereich, beispielsweise einem bestimmten Temperaturbereich, arbeitet.

In Abhängigkeit dieser Prüfung und/oder in Abhängigkeit der Elementinformationen wird dann das erste Funktionselement und/oder das zweite Funktionselement gesteuert. Beispielsweise können bei der Steuerung des ersten Funktionselements sowohl die Elementinformationen des ersten Funktionselements berücksichtigt werden als auch bei der Prüfung gewonnene Ergebnisse und/oder Erkenntnisse. Wenn für das zweite Funktionselement Elementinformationen vorliegen, beispielsweise weil diese aus dem zweiten Funktionselement ausgelesen wurden oder weil diese Elementinformationen des zweiten Funktionselements als Information in der Steuereinheit gespeichert sind kann auch eine Steuerung des zweiten Funktionselements in Abhängigkeit der Elementinformationen des zweiten Funktionselements erfolgen. Zusätzlich oder alternativ kann die Steuerung des zweiten Funktionselements in Abhängigkeit der Prüfung bzw. der dabei generierten Ergebnisse und/oder Erkenntnisse erfolgen.

Das hier beschriebene Verfahren sieht ferner vor, dass Prozessinformationen in dem Speicher des ersten Funktionselements gespeichert werden. Wenn auch das zweite Funktionselement einen Speicher aufweist, ist es bevorzugt, dass auch Prozessinformationen in dem Speicher des zweiten Funktionselements gespeichert werden können.

Die beschriebenen Prozessschritte müssen nicht zwangsläufig in der beschriebenen Reihenfolge durchgeführt werden, sondern können auch - sofern sinnvoll und machbarin anderer Reihenfolge durchgeführt werden. Insbesondere die Schritte der Durchführung einer Prüfung, des Steuerns des ersten und/oder zweiten Funktionselements und/oder des Speicherns von Prozessinformationen können in unterschiedlicher Reihenfolge und/oder in beliebiger Wiederholung erfolgen.

Wie auch im Folgenden noch weiter beschrieben wird, können neben dem ersten und zweiten Funktionselement auch weitere Funktionselemente in dem hier beschriebenen Verfahren eingesetzt werden und/oder Teil der hier beschriebenen Vorrichtung sein. Dabei gelten vorzugsweise die für das erste und/oder zweite Funktionselement beschriebenen Eigenschaften, Details und/oder Vorteile auch für eines, mehrere oder alle der weiteren Funktionselemente. Ferner ist vorzugweise vorgesehen, dass eines, mehrere oder alle der weiteren Funktionselemente an die Steuereinheit und/oder an die Auswerteeinheit angeschlossen werden, vorzugweise kabelgebunden oder kabellos. Eines, mehrere oder alle der Funktionselemente können auch untereinander verbunden sein, vorzugweise kabelgebunden oder kabellos.

Wenn im Folgenden von einem Funktionselement die Rede ist, gelten diese Angaben vorzugsweise auch für eines mehrere oder alle weiteren Funktionselemente ebenso sind Angaben, die im Folgenden mit Bezug auf Funktionselemente im Plural gemacht werden, diese ebenso auf ein einzelnes Funktionselement, beispielsweise das erste und/oder das zweite Funktionselement, anwendbar.

Eine optionale Auswerteeinheit kann vorzugsweise mit der Steuereinheit kabelgebunden oder kabellos verbunden sein und/oder räumlich beabstandet von der Steuereinheit angeordnet oder auch integral mit der Steuereinheit ausgebildet sein.

Das hier beschriebene Verfahren hat verschiedene Vorteile. Dadurch, dass das erste Funktionselement einen Speicher mit Elementinformationen aufweist, die von der Steuereinheit ausgelesen werden können, ist eine manuelle Erfassung dieser Elementinformationen nicht mehr erforderlich. Vielmehr ist es möglich, dass ein vereinfachter, vorzugsweise auch automatisierter, Auslesevorgang und/oder Informationsaustausch stattfindet.

Ein weiterer Vorteil ergibt sich dadurch, dass die aus dem ersten Funktionselement ausgelesenen Elementinformationen mit weiteren Informationen geprüft werden können, nämlich mit Elementinformationen die von dem zweiten Funktionselement ausgelesen sind, und/oder mit Informationen, die in der Steuereinheit gespeichert sind. Wie auch noch im Folgenden näher beschrieben wird, können hierbei beispielsweise Kompatibilitäten und/oder andere für die Prozesssicherheit relevante Prüfungen durchgeführt werden, sodass das Steuern des ersten und/oder zweiten Funktionselements dann in Abhängigkeit der Ergebnisse und/oder Erkenntnisse dieser Prüfung und/oder in Abhängigkeit der jeweiligen Elementinformationen erfolgen kann. Hierdurch kann also sichergestellt werden, dass beispielsweise miteinander nur in bestimmten Bereichen kompatible Funktionselemente auch nur in diesem kompatiblen Bereich (beispielsweise einem bestimmten Temperaturbereich) betrieben werden. Ein weiterer Vorteil des hier beschriebenen Verfahrens ergibt sich dadurch, dass Informationen nicht nur aus dem Speicher des ersten Funktionselements ausgelesen werden können, sondern auch Informationen, nämlich Prozessinformationen, in dem Speicher des ersten Funktionselements gespeichert werden können. Hierdurch ergibt sich die Möglichkeit, über den Lebenszyklus des Funktionselements immer wieder Prozessinformationen in dem Speicher des Funktionselements abspeichern zu können. Vorzugsweise können auch diese Prozessinformationen von der Steuereinheit ausgelesen und ferner vorzugsweise bei der Durchführung der Prüfung berücksichtigt werden. Auf diese Weise können beispielsweise Funktionselemente, deren maximale Betriebslaufzeit erreicht ist, von einer Verwendung ausgeschlossen werden.

Vorzugsweise ist das erste und/oder das zweite Funktionselement ausgewählt aus einer Gruppe umfassend Sensor, und/oder Aktor, und/oder Apparaturkomponente.

Das erste und/oder das zweite Funktionselement kann somit beispielsweise als Sensor, Aktor oder Apparaturkomponente ausgebildet sein. Ein als Sensor ausgebildetes Funktionselement kann beispielsweise ein Temperatursensor, ein pH-Sensor oder ein Levelsensor sein. Ein als Aktor ausgebildetes Funktionselement kann beispielsweise ein Rührer für einen Bioreaktor sein, ein Rührantrieb, eine Temperiereinheit (beispielsweise eine Heizmanschette, ein Kühlelement oder ein Heizelement) oder ein Begasungselement. Ein als Apparaturkomponente ausgebildetes Funktionselement kann beispielsweise ein Gefäß, etwa ein Bioreaktorgefäß, eine Kopfplatte, insbesondere eine Kopfplatte für einen Bioreaktor, oder ein Schlauch, beispielsweise ein Abgasschlauch oder ein Begasungsschlauch, sein. Funktionselemente können vorzugsweise auch Instrumente und/oder Werkzeuge sein, die beispielsweise in Operationssälen zum Einsatz kommen.

Wie auch bereits oben beschrieben, ist es bevorzugt, dass auch das zweite Funktionselement einen Speicher aufweist, in dem Elementinformationen gespeichert sind und die Elementinformationen Angaben über die Art und die Funktion des zweiten Funktionselements umfassen.

In einer bevorzugten Fortbildungsform umfasst das Verfahren Bereitstellen eines oder mehrerer weiterer Funktionselemente, wobei vorzugsweise eines oder mehrere oder alle der weiteren Funktionselemente jeweils einen Speicher aufweist, in dem Elementinformationen gespeichert sind und die Elementinformationen Angaben über die Art und die Funktion des jeweiligen Funktionselements umfassen. Wenn weitere Funktionselemente vorgesehen sind, ist es ferner bevorzugt, dass eines, mehrere oder alle dieser weiteren Funktionselemente jeweils einen Speicher aufweisen, in dem die Elementinformationen zu dem jeweiligen Funktionselement gespeichert sind.

Ferner ist vorzugweise vorgesehen, dass das Verfahren umfasst Auslesen der Elementinformationen aus dem zweiten Funktionselement, und/oder Auslesen der Elementinformationen aus einem, mehreren oder allen der weiteren Funktionselemente.

Dabei ist dann auch insbesondere bevorzugt, dass beim Durchführen der Prüfung die ausgelesenen Elementinformationen des zweiten und/oder eines, mehrerer oder aller weiteren Funktionselemente berücksichtigt werden.

Die hier beschriebenen bevorzugten Ausführungsformen haben jeweils einzeln aber auch in ihren jeweiligen möglichen Kombinationen verschiedene Vorteile. Komplexe Prozesse in der Bioprozesstechnik und/oder der Medizintechnik erfordern häufig eine Vielzahl von Funktionselementen. Je mehr diese Funktionselemente einen Speicher mit den jeweiligen Elementinformationen aufweisen, die dann auch vorzugsweise von der Steuereinheit ausgelesen werden können und gegebenenfalls auch beim Durchführen der Prüfung berücksichtigt werden können, desto stärker können beispielsweise die Prozesssicherheit und die Einhaltung von Qualitätsrichtlinien wie GMP auch in komplexen Prozessen unterstützt und/oder vereinfacht werden.

Gemäß einer bevorzugten Ausführungsform umfassen die Angaben über die Art des Funktionselements, ob das jeweilige Funktionselement als Sensor, Aktor oder Apparaturkomponente ausgebildet ist.

Ferner ist es bevorzugt, dass die Angaben über die Art des Funktionselements eine Seriennummer des jeweiligen Funktionselements und/oder eine Artikelnummer des jeweiligen Funktionselements umfassen und/oder eine Typangabe des jeweiligen Funktionselements umfassen und/oder Angaben über die Herstellung des jeweiligen Funktionselements umfassen.

Eine Typangabe eines Funktionselements kann die konkrete Art des Funktionselements weiter spezifizieren. Beispielsweise kann bei einem Rührantrieb als Typangabe angegeben sein, dass es sich um einen Überkopfantrieb und/oder einen Magnetantrieb handelt. Bei einer als Schlauch ausgebildeten Apparaturkomponente kann beispielsweise die Typangabe umfassen, dass es sich um einen beheizbaren Abgasschlauch handelt. Eine weitere bevorzugte Typangaben für Funktionselemente, beispielsweise für Bioreaktorgefäße und/oder Kopfplatten und/oder weitere Apparaturkomponenten, ist auch die Angabe darüber, ob es sich um Mehrweg- oder Einweg(Single-use)-Elemente handelt. Eine weitere bevorzugte Typangabe eines Funktionselements umfasst das Material und/oder eine Materialkombination des Funktionselements, beispielsweise ob ein Bioreaktorgefäß aus Glas oder Kunststoff ausgebildet ist.

Angaben über die Herstellung des jeweiligen Funktionselements können beispielsweise die bei der Herstellung verwendeten Materialien und/oder Herstellungsverfahren und/oder Werkzeuge umfassen. Ferner vorzugsweise können Ort und/oder Zeit der Herstellung und/oder der Durchführung einzelner Herstellungsschritte enthalten sein. Ferner vorzugsweise können auch Angaben über den Versand und/oder die Lagerung des Funktionselements enthalten sein. Diese Angaben über die Herstellung des jeweiligen Funktionselements ermöglichen es auch in vorteilhafter Weise Funktionselemente aus bestimmten Chargen oder mit einer bestimmten Herstellungshistorie schnell identifizieren zu können, beispielsweise im Rahmen eines Rückrufs.

Darüber hinaus ist insbesondere bevorzugt, dass die Angaben über die Funktion des Funktionselements umfassen Angaben über Betriebsparameter des jeweiligen Funktionselements, und/oder Angaben über Kompatibilitäten des jeweiligen Funktionselements mit anderen Funktionselementen, und/oder Angaben über die Verwendbarkeit des jeweiligen Funktionselements in verschiedenen Prozessen, und/oder Angaben über die Kalibrierung des jeweiligen Funktionselements, und/oder Angaben über die CE- und/oder UL-Kennzeichnung des jeweiligen Funktionselements, und/oder Angaben über die einzuhaltenden Service-Intervalle und/oder die maximale Betriebsdauer des jeweiligen Funktionselements.

Angaben über die Betriebsparameter eines jeweiligen Funktionselements können beispielsweise Maximalwerte, Grenzwerte, zulässige Parameter und/oder zulässige Betriebsmodi sein. Für einen Rührantrieb kann beispielsweise ein zulässiger Drehzahlbereich, insbesondere minimale und maximale Drehzahlen, Angaben über zulässigen Strom, zulässige Spannung oder Ähnliches hinterlegt sein. Zulässige Temperaturbereiche, insbesondere Minimal- oder maximal Temperaturen, beispielsweise sind in einer Vielzahl von Funktionselementen bevorzugte Betriebsparameter.

Die Angaben über Kompatibilitäten des jeweiligen Funktionselements mit anderen Funktionselementen können beispielsweise Informationen darüber enthalten, dass etwa eine bestimmte Temperiereinheit nur mit Glasgefäßen zu verwenden ist und/oder bei der Verwendung mit Kunststoff- oder Einweg-Gefäßen nur bis zu einer bestimmten Maximaltemperatur betrieben werden darf.

Angaben über die Verwendbarkeit des jeweiligen Funktionselements in verschiedenen Prozessen können beispielsweise Informationen darüber enthalten, dass bestimmte Typen von Rührern nur für bestimmte biotechnologische Prozesse eingesetzt werden dürfen, für andere nicht. Dies kann etwa dann von Vorteil sein, wenn empfindliche Zellkulturen zu durchmischen sind, und hierfür nur Rührer mit entsprechend geformten langsam drehenden Rührelementen zum Einsatz kommen sollen.

Die Angaben über die Kalibrierung des jeweiligen Funktionselements können beispielsweise Angaben darüber enthalten, welche Kalibrierung in dem jeweiligen Funktionselement durchgeführt wurde und/oder Angaben darüber, zu welchen Zeitpunkten und/oder in welchen Abständen welche Kalibrierung des jeweiligen Funktionselements wie durchzuführen sind. Dies kann in vorteilhafter Weise auch eine automatische Kalibrierung des jeweiligen Funktionselements erlauben.

Die Angaben über die CE- und oder die UL-Kennzeichnung des jeweiligen Funktionselements sind zur Sicherstellung der Prozesssicherheit ebenfalls von Vorteil.

Die Angaben über die einzuhaltenden Service-Intervalle und/oder eine maximale Betriebsdauer des jeweiligen Funktionselements fördern ebenfalls die Prozesssicherheit, da vorzugsweise Warnhinweise ausgegeben werden, wenn Funktionselemente eingesetzt werden sollen, deren Serviceintervalle und/oder maximale Betriebsdauer überschritten ist. Eine maximale Betriebsdauer kann vorzugsweise Angaben über eine maximale Gesamtbetriebsdauer im Sinne eines maximalen Produktlebenszyklus enthalten und/oder darüber, wie lange ein Funktionselement maximal am Stück in einem bestimmten Prozess eingesetzt und/oder betrieben werden darf.

Wie auch im Folgenden noch näher beschrieben wird, können einige oder alle der Angaben über die Art und/oder die Funktion des Funktionselements geändert und/oder ergänzt werden. Dabei ist es von Vorteil, wenn bestimmte Angaben änderungs- und/oder schreibgeschützt sind, damit diese Angaben während des gesamten Lebenszyklus des Funktionselements nicht verändert werden können. Andere Angaben wiederum können vorzugsweise ergänzt und/oder geändert werden, beispielsweise um durchgeführte Wartungsmaßnahmen zu vermerken und/oder beispielsweise eine aus bestimmten Gründen verkürzte maximale Betriebsdauer zu vermerken und/oder um neue Erkenntnisse hinsichtlich Kompatibilitäten, beispielsweise mit neu entwickelten Funktionselementen, zu ergänzen.

Vorzugsweise können Angaben, die geändert und/oder ergänzt werden können, unterschiedlichen Berechtigungen unterlegen, sodass bestimmte Angaben nur von bestimmten, hierzu berechtigten Stellen durchgeführt werden können.

In einer weiteren bevorzugten Ausführungsform ist vorgesehen, dass Informationen, die in der Steuereinheit gespeichert sind, umfassen Angaben über Kompatibilitäten von Funktionselementen, und/oder Angaben über die Verwendbarkeit von Funktionselementen in verschiedenen Prozessen, und/oder Angaben über durchzuführende Prozesse, wie Art und/oder Dauer des jeweiligen Prozesses, und/oder Angaben der in einem Prozess zu verwendenden Prozessparameter.

Die bereits oben beschriebenen Angaben über Kompatibilitäten von Funktionselementen können auch in der Steuereinheit gespeichert sein. Dies hat beispielsweise den Vorteil, dass mit einem Update der Steuereinheit gleichzeitig eine Vielzahl von Angaben über Kompatibilitäten verschiedene, beispielsweise auch neu hinzugekommen, Funktionselementen gespeichert werden können.

In der Steuereinheit sind vorzugsweise auch die Angaben gespeichert, die für die Durchführung von Prozessen erforderlich sind, insbesondere die Art und/oder Dauer des durchzuführenden Prozesses und/oder die in einem Prozess zu verwendenden Prozessparameter. Zusammen mit den Angaben über die Art und Funktion der Funktionselemente können die in der Steuereinheit gespeicherten Informationen vorteilhaft beim Durchführen der Prüfung eingesetzt werden, um beispielsweise festzustellen, ob die in einem durchzuführenden Prozess zu verwendenden Prozessparameter und/oder die im Prozess einzusetzenden Funktionselemente hierfür zulässig und geeignet sind.

In einer weiteren bevorzugten Ausführungsform umfassen die Prozessinformationen Angaben über einen durchgeführten Prozess, wie Art und/oder Dauer des Prozesses, und/oder Angaben der in einem Prozess verwendeten Prozessparameter, und/oder Angaben der Betriebsparameter, mit der das jeweilige Funktionselement und/oder weitere Funktionselemente in einem Prozess betrieben wurden, und/oder Angaben über zusammen mit dem jeweiligen Funktionselement verwendeten weiteren Funktionselemente, insbesondere deren Elementinformationen oder Teile davon, und/oder Angaben über Prozessergebnisse und/oder Prozessfehler.

Prozessinformationen, die im Funktionselement gespeichert werden können, enthalten vorzugsweise Informationen, die darüber Auskunft geben können, wann, wo (beispielsweise in welchem Prozess) und wie (beispielsweise mit welchen anderen Funktionskomponenten und/oder mit welchen Betriebs- und/oder Prozessparametern) ein Funktionselement eingesetzt wurde. Diese Angaben können beispielsweise dazu dienen, Serviceintervalle und/oder erforderliche Wartungsmaßnahmen und/oder eine maximale Betriebsdauer festzulegen oder zu verändern.

In einer weiteren Ausgestaltung ist es bevorzugt, dass das Durchführen der Prüfung umfasst Vergleichen der Kompatibilitäten von Funktionselementen, insbesondere hinsichtlich deren gemeinsamer Verwendung und/oder deren Verwendbarkeit in einem geplanten Prozess und/oder deren Verwendbarkeit in einer geplanten Prozessumgebung.

Beim Durchführen der Prüfung ist es insbesondere bevorzugt, dass die Kompatibilitäten von Funktionselementen untereinander und/oder in bestimmten Prozessen und/oder in bestimmten Prozessumgebungen geprüft werden. Hierzu werden vorzugsweise die hierzu vorliegenden Informationen verglichen, beispielsweise in der Steuereinheit und/oder einer Auswerteeinheit, und ferner vorzugsweise ein Vergleichsergebnis ausgewertet.

Beispiele für Prüfungen können sein, dass geprüft wird, ob für einen durchzuführenden Prozess und die dafür vorgesehenen Prozessparameter und die dafür vorgesehene Prozessumgebung geprüft wird, ob die für den Einsatz in diesem Prozess vorgesehenen Funktionselemente geeignet sind insbesondere hinsichtlich der Angaben über die Art und Funktion dieser Funktionselemente. Beispielsweise für die Kultivierung einer Zellkultur in einem Einweg-Bioreaktor wäre vorzugsweise unter anderem zu prüfen, ob sämtliche Funktionselemente für die Verwendung mit einem Einweg-Bioreaktor ausgebildet sind, und ob der durchzuführende Prozess eine für einen Einweg-Bioreaktor einzuhaltenden Maximaltemperatur nicht überschreitet. Ferner wäre beispielsweise zu prüfen, ob der für den Einsatz vorgesehenen Rührer auch eine Ausgestaltung der Rührelemente aufweist, die fürdie Kultivierung von Zellkulturen geeignet ist. Ebensolche Prüfungen können für eine Begasung, Abgasführung, Zu- oder Abführung von Medien, Temperaturkontrolle, pH-Kontrolle und andere Bereiche durchgeführt werden.

Die Durchführung einer Prüfung unter Berücksichtigung der jeweiligen Informationen und/oder Angaben hat unter anderem den Vorteil, dass bei der Steuerung eines oder mehrerer Funktionselemente das Ergebnis dieser Prüfung berücksichtigt werden kann. Beispielsweise kann in einem bestimmten Prozess, wie etwa der Kultivierung von Zellkulturen, eine maximale Drehzahl für den Rührantrieb vorgegeben sein. Der Antrieb würde demnach dann von der Steuereinheit so gesteuert werden, dass er diese vom Prozess vorgegebene maximale Drehzahl nicht überschreitet, obwohl die maximal zulässige Drehzahl des Antriebs gegebenenfalls noch weit darüber liegt. Ferner kann beispielsweise eine Temperiereinheit so angesteuert werden, dass sie eine bestimmte Temperatur, die für den Prozess maximal zulässig ist, beispielsweise um die Zellkulturen nicht zu gefährden, nicht überschreitet, auch wenn die Temperiereinheit eine deutlich höhere Heizleistung aufweist.

Eine weitere bevorzugte Ausführungsform zeichnet sich aus durch Konfigurieren des ersten und/oder des zweiten und/oder eines oder mehrerer der weiteren Funktionselemente und/oder eines durchzuführenden Prozesses in Abhängigkeit der Prüfung. Das Konfigurieren kann vorzugsweise nach dem Anschließen des bzw. der Funktionselemente an die Steuereinheit erfolgen, ferner vorzugsweise nach dem Auslesen der Elementinformationen, ferner vorzugsweise nach dem Durchführen der Prüfung. Das Konfigurieren kann vorzugsweise vor oder parallel zum Steuern der Funktionselemente erfolgen.

Das Konfigurieren von Funktionselementen und/oder Prozessen kann vorzugsweise die Auswahl und/oder Einstellung von Betriebsparametern und/oder Prozessparametern und/oder Einstellungsoptionen und ähnlichem umfassen. Beispielsweise können Funktionselemente unterschiedliche Betriebsmodi oder Einstellmöglichkeiten aufweisen und/oder durchzuführende Prozesse in unterschiedlichen möglichen Varianten ausgeführt werden. Wenn sich in Abhängigkeit der Prüfung ergibt, dass die Konstellation der einzusetzenden Funktionselemente und der durchzuführende Prozess eine bestimmte Art bzw. Variante des Prozesses und/oder bestimmte Einstellungen und/oder Betriebsparameter von Funktionselementen erfordern, werden diese vorzugsweise von der Steuereinheit entsprechend konfiguriert.

Eine weitere bevorzugte Ausführungsform des Verfahrens ist gekennzeichnet durch Speichern von Prozessinformationen in dem Speicher der Steuereinheit, und/oder Speichern von Prozessinformationen in einem Speicher einer Auswerteeinheit.

Vorzugsweise können Prozessinformationen nicht nur im Speicher eines oder mehrerer Funktionselemente gespeichert werden, sondern ebenfalls im Speicher der Steuereinheit und/oder im Speicher der Auswerteeinheit. Auf diese Weise stehen Prozessinformationen auch an diesen Stellen für weitere Prüfungen und/oder Auswertungen zur Verfügung. Die im Speicher der Steuereinheit und/oder im Speicher der Auswerteeinheit gespeicherten Informationen können identisch sein zu den in einem oder mehreren der Funktionselemente gespeicherten Informationen oder von diesen verschieden.

Ein weiteres bevorzugtes Ausführungsbeispiel kennzeichnet sich aus durch Speichern von Serviceinformationen in dem Speicher des ersten und/oder des zweiten und/oder eines weiteren Funktionselements, und/oder Speichern von Kundeninformationen in dem Speicher des ersten und/oder des zweiten und/oder eines weiteren Funktionselements.

Serviceinformationen können beispielsweise Angaben enthalten, die für die Wartung und/oder Betriebstauglichkeit von Funktionselementen relevant sind. Vorzugsweise sind nur bestimmte Stellen berechtigt, das Speichern von Serviceinformationen in dem Speicher eines Funktionselements zu initiieren, beispielsweise entsprechend autorisierte Servicetechniker. Kundeninformationen können beispielsweise nutzerspezifische Informationen umfassen, beispielsweise eine kundenindividuelle Elementbezeichnung, Einsatzort eines Funktionselements beim Kunden oder ähnliches. Vorzugsweise kann das Speichern von Kundeninformationen im Speicher eines Funktionselements vom Kunden initiiert werden. Beispielsweise kann es bevorzugt sein, dass ein Kunde keine Berechtigung hat, das Speichern von anderen Informationen außer von Kundeninformationen im Speicher eines Funktionselements zu initiieren. Die Serviceinformationen und/oder Kundeninformationen können ein Teil der Elementinformationen bilden oder auch separat Elementinformationen im Speicher des Funktionselements abgelegt sein.

Eine weitere bevorzugte Ausführungsform des Verfahrens ist gekennzeichnet durch Speichern von Elementinformationen.

Neben dem Speichern von Prozessinformationen im Speicher des Funktionselements ist es ebenfalls bevorzugt, auch Elementinformationen im Speicher des Funktionselements abspeichern zu können. Hierbei können beispielsweise bestehende Elementinformationen geändert werden, beispielsweise durch Überschreiben. Elementinformationen können auch ergänzt werden. Dies hat den Vorteil, dass die Elementinformationen immer auf dem neuesten Stand gehalten werden können, was beispielsweise dann besonders wichtig sein kann für die Prozesssicherheit, wenn sich Elementinformationen ändern oder zusätzliche Informationen zu Elementinformationen erforderlich sind, beispielsweise um verbesserte Prüfungen durchführen zu können.

Eine weitere bevorzugte Ausführungsform ist dadurch gekennzeichnet, dass der Speicher des ersten und/oder des zweiten und/oder eines weiteren Funktionselements ein digitaler nichtflüchtiger Speicher ist, insbesondere ein EEPROM oder FRAM, beispielsweise ein One-Wire-EEPROM. Diese bevorzugten Speichervarianten haben den Vorteil, eine kostengünstige, robuste und zuverlässige Lösung darzustellen, die gleichzeitig energieeffizient ist.

Ferner ist es bevorzugt, dass der Speicher des ersten und/oder des zweiten und/oder eines weiteren Funktionselements fluiddicht ausgebildet ist, vorzugsweise gasdicht und/oder flüssigkeitsdicht. Diese Ausgestaltungsform macht die Funktionselemente in vorteilhafter Weise besonders geeignet für Prozesse, in denen die Funktionselemente bzw. ihre Speicher Prozessmedien ausgesetzt sein können.

In einer weiteren bevorzugten Ausgestaltung des Verfahrens ist vorgesehen, dass der Speicher des ersten und/oder des zweiten und/oder eines weiteren Funktionselements sterilisierbar ist, vorzugsweise autoklavierbar und/oder strahlensterilisierbar, beispielsweise beta-sterilisierbar und/oder gamma-sterilisierbar. Insbesondere wenn es sich bei den Funktionselementen um Mehrweg-Elemente handelt, ist die Eigenschaft, dass die Funktionselemente sterilisiert und/oder autoklaviert werden können, von Vorteil.

Dabei ist es insbesondere bevorzugt, dass der Speicher des ersten und/oder des zweiten und/oder eines weiteren Funktionselements eine Temperaturbeständigkeit von mindestens 100 Grad Celsius, vorzugsweise von mindestens 110 Grad Celsius, vorzugsweise von mindestens 120 Grad Celsius, vorzugsweise von mindestens 130 Grad Celsius, vorzugsweise von mindestens 150 Grad Celsius, aufweist.

Diese bevorzugten Temperaturbeständigkeiten machen die Funktionselemente geeignet für einen großen Bereich von Prozesstemperaturen, so dass die Funktionselemente solchen Temperaturen, beispielsweise zur Sterilisierung oder Autoklavierung, ausgesetzt werden können.

Die hier beschriebenen bevorzugten Merkmale und Details können jeweils allein oder in beliebiger Kombination miteinander als vorteilhafte Ausausführungsformen bevorzugt sein.

Gemäß einem weiteren Aspekt der Erfindung wird die eingangs genannte Aufgabe gelöst durch die Anwendung des zuvor beschriebenen Verfahrens in der Bioprozesstechnik und/oder in der Medizintechnik.

Gemäß einem weiteren Aspekt wird die eingangs genannte Aufgabe gelöst durch eine Vorrichtung zur Anwendung in der Bioprozesstechnik und/oder in der Medizintechnik, umfassend ein erstes Funktionselement, das einen Speicher aufweist, in dem Elementinformationen gespeichert sind und die Elementinformationen Informationen über die Art und die Funktion des ersten Funktionselements umfassen, ein zweites Funktionselement, und eine Steuereinheit, wobei die Steuereinheit ausgebildet ist, die Elementinformationen aus dem ersten Funktionselement auszulesen und eine Prüfung der ausgelesenen Elementinformationen des ersten Funktionselements durchzuführen mit Elementinformationen, die von dem zweiten Funktionselement ausgelesen sind und/oder mit Informationen, die in der Steuereinheit gespeichert sind, wobei die Steuereinheit ausgebildet ist, mindestens eines des ersten und des zweiten Funktionselements in Abhängigkeit der Prüfung und/oder in Abhängigkeit der Elementinformationen zu steuern, und wobei die Steuereinheit ausgebildet ist, Prozessinformationen in dem Speicher des ersten Funktionselements zu speichern.

Gemäß einem weiteren Aspekt wird die eingangs genannte Aufgabe gelöst durch die Verwendung einer zuvor beschriebenen Vorrichtung in der Bioprozesstechnik und/oder in der Medizintechnik.

Gemäß einem weiteren Aspekt wird die eingangs genannte Aufgabe gelöst durch ein Funktionselement für eine zuvor beschriebene Vorrichtung zur Anwendung in der Bioprozesstechnik und/oder in der Medizintechnik und/oder für ein zuvor beschriebenes Verfahren, wobei das Funktionselement einen Speicher aufweist, in dem Elementinformationen gespeichert sind und die Elementinformationen Informationen über die Art und die Funktion des ersten Funktionselements umfassen, wobei das Funktionselement ausgebildet ist, von einer Steuereinheit gesteuert zu werden, und wobei der Speicher ausgebildet ist, von der Steuereinheit und/oder einer Auswerteeinheit ausgelesen zu werden, und wobei der Speicher ausgebildet ist, dass von der Steuereinheit und/oder einer Auswerteeinheit Prozessinformationen in dem Speicher speicherbar sind.

Das hier beschriebene Verfahren und seine möglichen Fortbildungen weisen vorzugsweise Merkmale bzw. Verfahrensschritte auf, die sie insbesondere dafür geeignet machen, mit einer hier beschriebenen Vorrichtung und/oder einem hier beschriebenen Funktionselement und den jeweiligen möglichen Fortbildungen verwendet zu werden. Ferner weisen die hier beschriebene Vorrichtung, insbesondere mit einem hier beschriebenen Funktionselement und/oder das hier beschriebene Funktionselement und die jeweiligen möglichen Fortbildungen vorzugsweise Merkmale auf, die sie insbesondere dafür geeignet machen, mit einer hier beschriebenen Verfahren und seinen möglichen Fortbildungen verwendet zu werden.

Zu den Vorteilen, Ausführungsvarianten und Ausführungsdetails dieser weiteren Aspekte und ihrer jeweiligen möglichen Fortbildungen wird auch auf die vorangegangene Beschreibung zu den entsprechenden Verfahrensmerkmalen verwiesen.

Die zuvor beschriebene Vorrichtung und das zuvor beschriebene Verfahren sowie das zuvor beschriebene Funktionselement eignen sich insbesondere zur Verwendung in der Bioprozesstechnik und/oder in der Medizintechnik.

Bevorzugte Ausführungsbeispiele werden beispielhaft anhand der beiliegenden Figuren beschrieben. Es zeigen:
- Figur 1:: eine schematische Darstellung eines Flussdiagramms eines Beispiels eines Verfahren zum Steuern von Funktionselementen in der Bioprozesstechnik und/oder in der Medizintechnik;
- Figur 2:: eine schematische Darstellung eines Beispiels einer Vorrichtung zur Anwendung in der Bioprozesstechnik und/oder in der Medizintechnik;
- Figur 3:: eine schematische Darstellung eines Beispiels von Elementinformationen und Prozessinformationen im Speicher eines Funktionselements; und
- Figur 4:: eine schematische Darstellung eines Beispiels von in einer Steuereinheit gespeicherten Informationen.

In den Figuren sind gleiche oder im Wesentlichen funktionsgleiche Elemente mit den gleichen Bezugszeichen versehen. Allgemeine Beschreibungen beziehen sich in der Regel auf alle Ausführungsformen, sofern Unterschiede nicht explizit angegeben sind.

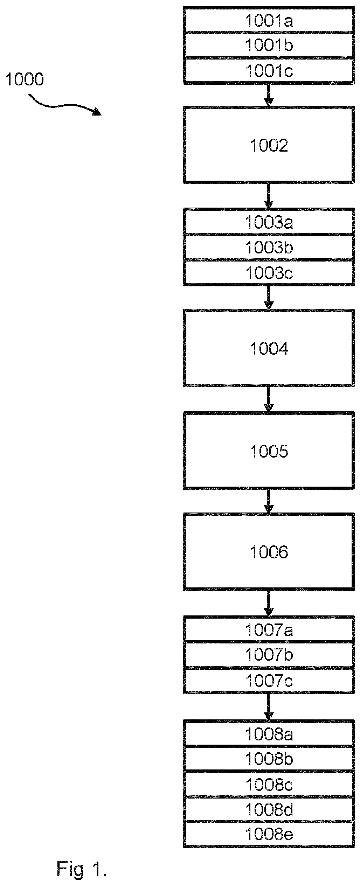

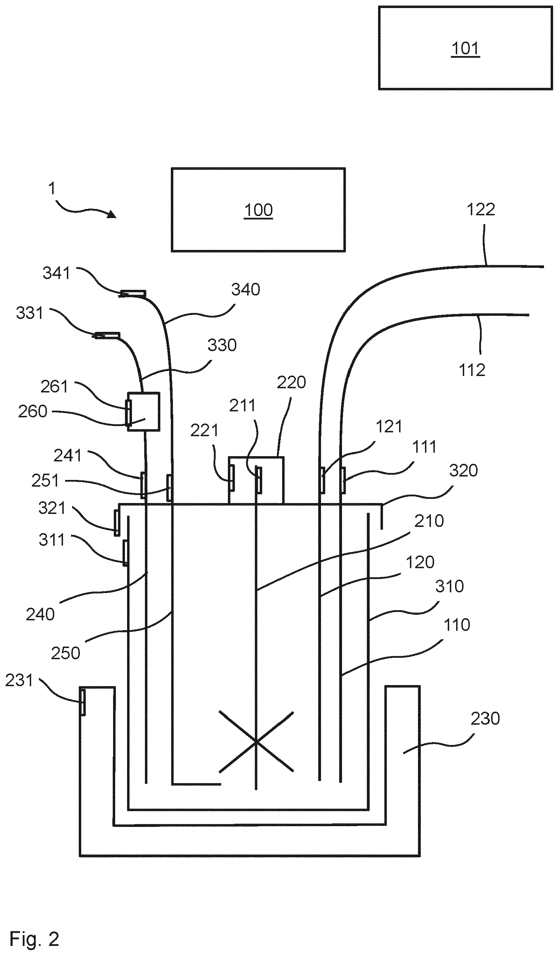

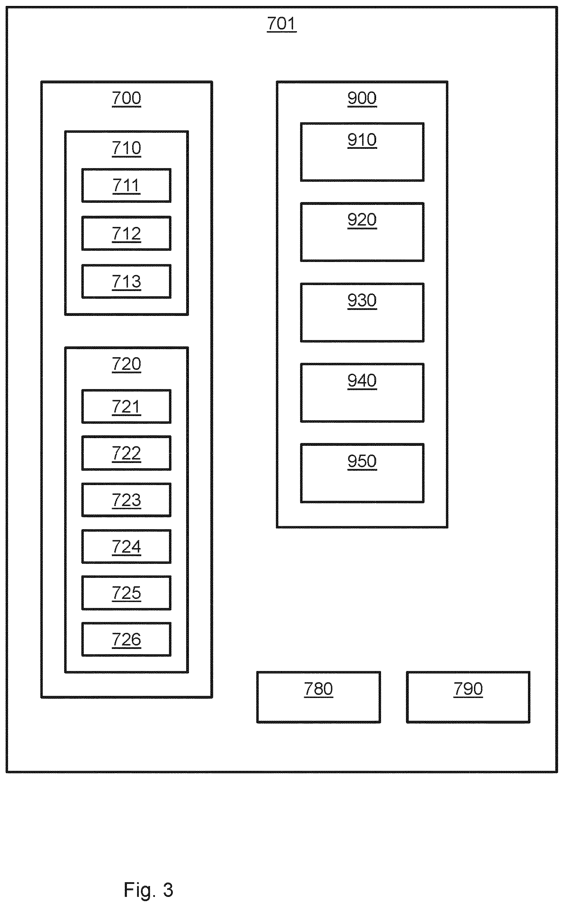

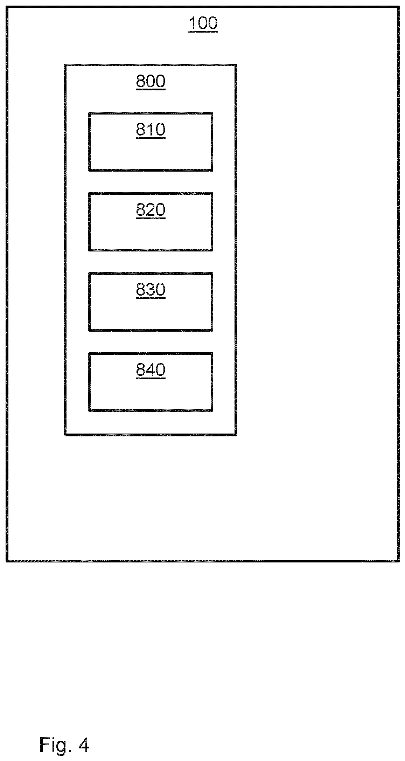

Figur 1 zeigt eine schematische Darstellung eines Flussdiagramms eines Beispiels eines Verfahrens 1000 zum Steuern von Funktionselementen 110, 120, 210, 220, 230, 240, 250, 260, 310, 320, 330, 340 in der Bioprozesstechnik und/oder in der Medizintechnik. In Figur 2 ist ein Beispiel einer Vorrichtung zur Anwendung in der Bioprozesstechnik/oder in der Medizintechnik schematisch dargestellt, hier in Form des Bioreaktors 1. In den Figuren 3 und 4 sind Beispiele von Elementinformationen 700 und Prozessinformationen 900 im Speicher 701 eines Funktionselements (Figur 3) sowie ein Beispiel für in einer Steuereinheit 100 gespeicherte Informationen 800 (Figur 4) dargestellt.

Das Verfahren 1000 und seine Schritte werden im Folgenden anhand des in Figur 2 dargestellten Beispiels einer Vorrichtung zur Anwendung in der Bioprozesstechnik und/oder in der Medizintechnik, hier in Form eines Bioreaktors 1, erläutert. Das Verfahren und die Vorrichtung sind jedoch nicht auf die hier gezeigten Beispiele und Merkmalskombinationen eingeschränkt.

Der in Figur 2 beispielhaft gezeigte Bioreaktor 1 ist mit einer Steuereinheit 100 sowie mit einer Auswerteeinheit 101 verbunden. Die Verbindung zwischen dem Bioreaktor 1 und der Auswerteeinheit 101 kann direkt oder indirekt über die Steuereinheit 100 erfolgen, und ferner kann die Verbindung zwischen dem Bioreaktor 1 und Steuereinheit 100 und der Auswerteeinheit 101 kabelgebunden oder kabellos erfolgen.

Der Bioreaktor 1 weist mehrere Funktionselemente auf, und zwar sowohl Sensoren, Aktoren und Apparaturkomponenten.

Als Apparaturkomponenten weist der Bioreaktor 1 ein Bioreaktorgefäß 310 und eine Kopfplatte 320 sowie einen Abgasschlauch 330 und einen Begasungsschlauch 340 auf.

Als Aktoren weist der Bioreaktor 1 einen Rührer 210 sowie einen Rührantrieb 220 auf und ferner eine Temperiereinheit 230 und eine Heizmanschette 260 für den Abgasschlauch 330. Weitere Aktoren sind eine Begasungssonde 250 sowie ein Entgasungsrohr 240.

Der Bioreaktor 1 weist zudem einen Temperatursensor 110 und einen pH-Sensor 120 auf, die über Leitungen 112, 122 an weitere Komponenten angeschlossen werden können, beispielsweise an die Steuereinheit 100 und/oder die Auswerteeinheit 101.

Der Abgasschlauch 330 und/oder der Begasungsschlauch 340 können vorzugweise ebenfalls an (hier nicht dargestellte) Medienreservoirs oder weitere Komponenten angeschlossen werden. Der Rührantrieb 220 ist vorzugsweise mit einer Energiequelle (nicht dargestellt) verbunden.

In dem in Figur 2 gezeigten Beispiel weisen alle Funktionselemente 110, 120, 210, 220, 230, 240, 250, 260, 310, 320, 330, 340 jeweils einen Speicher auf, die im Folgenden noch näher dargestellt wird. Es sind jedoch auch Ausgestaltungen möglich, in denen nur ein Funktionselement, zwei Funktionselemente oder mehrere Funktionselemente jeweils einen Speicher aufweisen.

Beispielsweise weist der Rührer 210 einen Speicher 211 auf, der Rührantrieb 220 einen Speicher 221. Das Bioreaktorgefäß 310 weist einen Speicher 311 auf und die Kopfplatte 320 einen Speicher 321. Die Temperiereinheit 230 weist einen Speicher 231 auf. Die Begrenzungssonde 250 weist einen Speicher 251 auf und der mit der Begasungssonde 250 verbundene Begasungsschlauch 340 weist einen Speicher 341 auf. Das Entgasungsrohr 240 weist einen Speicher 241 auf und der mit dem Entgasungsrohr 240 verbundene Abgasschlauch 330 weist einen Speicher 331 auf. Die Heizmanschette 260 für den Abgasschlauch 230 weist einen Speicher 261 auf. Die beiden Sensoren 110, 120 weisen jeweils einen Speicher 111, 121 auf. Jeder der Speicher 111, 121, 211, 221, 231, 241, 251, 261, 311, 321, 331, 341 der Funktionselemente 110, 120, 210, 220, 230, 240, 250, 260, 310, 320, 330, 340 kann wie der in Figur 3 gezeigte Speicher 701 oder ähnlich aufgebaut sein.

Im in Figur 1 dargestellten Beispiel des Verfahrens 1000 zum Steuern von Funktionselementen 110, 120, 210, 220, 230, 240, 250, 260, 310, 320, 330, 340 in der Bioprozesstechnik und/oder in der Medizintechnik werden im Schritt 1001a zunächst ein erstes Funktionselement, hier beispielsweise in Form des Bioreaktorgefäßes 310 und in Schritt 1001b ein zweites Funktionselement, hier beispielsweise in Form des Rührers 210, bereitgestellt, und in Schritt 1001c die weiteren Fraktionselemente, beispielsweise in Form der weiteren mit Bezug auf Figur 2 beispielhaft genannten Funktionselemente 110, 120, 220, 230, 240, 250, 260, 320, 330, 340, bereitgestellt.

Im Schritt 1002 werden die Funktionselemente 110, 120, 210, 220, 230, 240, 250, 260, 310, 320, 330, 340 an die Steuereinheit 1000 angeschlossen, vorzugsweise kabelgebunden oder kabellos.

Im Schritt 1003a erfolgt das Auslesen von Elementinformationen 700 aus dem Speicher 311 des ersten Funktionselements in Form des Bioreaktorgefäßes 310. Im Schritt 1003b erfolgt das Auslesen der Elementinformationen aus dem Speicher 211 des zweiten Funktionselements in Form des Rührers 210. Im Schritt 1003c erfolgt das Auslesen der weiteren Elementinformationen aus den Speichern 111, 121, 221, 231, 241, 251, 261, 321, 331, 341 der weiteren Funktionselemente 110, 120, 220, 230, 240, 250, 260, 320, 330, 340.

In Schritt 1004 erfolgt das Durchführen einer Prüfung der ausgelesenen Elementinformationen 700 aus den verschiedenen Funktionselementen Funktionselemente 110, 120, 210, 220, 230, 240, 250, 260, 310, 320, 330, 340 bzw. deren Speicher 111, 121, 211, 221, 231, 241, 251, 261, 311, 321, 331, 341 und/oder mit Informationen 800, den der Steuereinheit 100 gespeichert sind.

Im Schritt 1005 erfolgt vorzugsweise eine Konfiguration eines oder mehrerer der Funktionselemente 110, 120, 210, 220, 230, 240, 250, 260, 310, 320, 330, 340 und/oder eines durchzuführenden Prozesses in Abhängigkeit der im Schritt 1004 durchgeführten Prüfung.

Im Schritt 1006 erfolgt dann das Steuern der Funktionselemente 110, 120, 210, 220, 230, 240, 250, 260, 310, 320, 330, 340, insbesondere mittels der Steuereinheit 100, in Abhängigkeit der in Schritt 1004 durchgeführten Prüfung und/oder in Abhängigkeit der elementaren Funktionen 700.

In den Schritten 1007a,b,c erfolgt dann das Speichern von Prozessinformationen 900 in dem Speicher 111, 121, 211, 221, 231, 241, 251, 261, 311, 321, 331, 341 der Funktionselemente 110, 120, 210, 220, 230, 240, 250, 260, 310, 320, 330, 340.

Im Schritt 1008a erfolgt dann vorzugsweise das Speichern von Prozessinformationen 900 auch im Speicher der Steuereinheit 100 und/oder im Schritt 1008b das Speichern von Prozessinformationen 900 in einem Speicher der Auswerteeinheit 101.

Vorzugsweise erfolgt im Schritt 1008c das Speichern von Serviceinformationen 780 und/oder von Kundeninformationen 790 im Speicher 111, 121, 211, 221, 231, 241, 251, 261, 311, 321, 331, 341 eines oder mehrerer Funktionselemente 110, 120, 210, 220, 230, 240, 250, 260, 310, 320, 330, 340.

Der in Figur 3 beispielhaft dargestellte Speicher 701 enthält Elementinformationen 700, Prozessinformationen 900, Serviceinformationen 780 und Kundeninformationen 790. Vorzugsweise können einer, zwei, mehrere oder alleder Speicher 111, 121, 211, 221, 231, 241, 251, 261, 311, 321, 331, 341 der Funktionselemente 110, 120, 210, 220, 230, 240, 250, 260, 310, 320, 330, 340 wie der in Figur 3 beispielhaft dargestellte Speicher 701 ausgebildet sein.

Die Elementinformationen 700 umfassen vorzugsweise Angaben 710 über die Art des Funktionselements und/oder Angaben 720 Option des Funktionselements. Die Angaben 710 über die Art des Funktionselements können beispielsweise eine Seriennummer 711, eine Artikelnummer 712 oder eine Typangabe 713 umfassen. Die Angaben 720 über die Funktion des Funktionselements können beispielsweise umfassen Angaben 721 über die Betriebsparameter, Angaben 722 über Kompatibilitäten, Angaben 723 über die Verwendbarkeit des jeweiligen Funktionselements in verschiedenen Prozessen, Angaben 724 über die Kalibrierung des jeweiligen Funktionselements, Angaben 721 über die CE- und/oder UL-Kennzeichnung überlegen Funktionselements, Angaben 700 sechsten 20 über einzuhaltende Serviceintervalle und/oder maximale Betriebsdauer des Punktionselements.

Die Prozessinformationen 900 können vorzugsweise Angaben 910 über einen durchgeführten Prozess, Angaben 920 in einem Prozess verwendeten Prozessparameter, Angaben 930 der Betriebsparameter, mit der Funktionselement in einem Prozess betrieben wurden, und/oder an Angaben 940 über zusammen mit dem Funktionselement verwendeten weiteren Funktionselemente und/oder Angaben 950 über Prozessergebnisse und/oder Prozessfehler enthalten.

Ferner können in Speicher 701 Serviceinformationen 780 und/oder Kundeninformationen 790 gespeichert sein.

Die in einem Speicher der Steuereinheit 100 gespeicherten Informationen 800 können beispielsweise Angaben 810 über Kompatibilitäten von Funktionselementen, Angaben 820 über die Verwendbarkeit von Funktionselementen in verschiedenen Prozessen, Angaben 830 über durchzuführenden Prozesse, und/oder Angaben 840 der in einem Prozess zu verwenden Prozessparameter umfassen.

Vorzugsweise können die Elementinformationen 700, die Prozessinformationen 900, die Serviceinformationen 780 und/oder die unten Informationen 790 in einem Speicher 701 eines Funktionselements jeweils nur von einer dazu berechtigten Stelle ergänzt und/oder geändert werden. Beispielsweise kann die Berechtigung zur Ergänzung und/oder Änderung von Serviceinformationen 780 auf hierfür autorisiertes Servicepersonal beschränkt sein. Kundeninformationen 790 hingegen können beispielsweise auch von Kunden geändert/oder ergänzt werden. Elementinformationen 700 können beispielsweise bevorzugt nur vom Hersteller bzw. von ihm autorisierten Stellen ergänzt und/oder geändert werden.

Mit der hier beschriebenen Lösung wird es in vorteilhafter und effizienter Weise unter anderem möglich, die Prozesssicherheit zu erhöhen und die Einhaltung von Qualitätsrichtlinien wie GMP zu erleichtern und hierfür erforderliche Dokumentationen einfacher zu erstellen und nachzuhalten.

## Patentansprüche

1. Verfahren zum Steuern von Funktionselementen in der Bioprozesstechnik und/oder in der Medizintechnik,
umfassend
- Bereitstellen eines ersten Funktionselements, das einen Speicher aufweist, in dem Elementinformationen gespeichert sind und die Elementinformationen Angaben über die Art und die Funktion des ersten Funktionselements umfassen,
- Bereitstellen eines zweiten Funktionselements,
- Anschließen des ersten und des zweiten Funktionselements an eine Steuereinheit,
- Auslesen der Elementinformationen aus dem ersten Funktionselement,
- Durchführen einer Prüfung der ausgelesenen Elementinformationen des ersten Funktionselements mit Elementinformationen, die von dem zweiten Funktionselement ausgelesen sind und/oder mit Informationen, die in der Steuereinheit gespeichert sind,
- Steuern mindestens eines des ersten und des zweiten Funktionselements in Abhängigkeit der Prüfung und/oder in Abhängigkeit der Elementinformationen,
- Speichern von Prozessinformationen in dem Speicher des ersten Funktionselements.

2. Verfahren nach dem vorhergehenden Anspruch,
**dadurch gekennzeichnet, dass** das erste und/oder das zweite Funktionselement ausgewählt ist aus einer Gruppe umfassend
- Sensor, und/oder
- Aktor, und/oder
- Apparaturkomponente.

3. Verfahren nach mindestens einem der vorhergehenden Ansprüche,
**dadurch gekennzeichnet, dass** das zweite Funktionselement einen Speicher aufweist, in dem Elementinformationen gespeichert sind und die Elementinformationen Angaben über die Art und die Funktion des zweiten Funktionselements umfassen.

4. Verfahren nach mindestens einem der vorhergehenden Ansprüche, **gekennzeichnet durch**
- Bereitstellen eines oder mehrerer weiterer Funktionselemente, wobei vorzugsweise eines oder mehrere oder alle der weiteren Funktionselemente jeweils einen Speicher aufweist, in dem Elementinformationen gespeichert sind und die Elementinformationen Angaben über die Art und die Funktion des jeweiligen Funktionselements umfassen, und/oder
- Auslesen der Elementinformationen aus dem zweiten Funktionselement, und/oder
- Auslesen der Elementinformationen aus einem, mehreren oder allen der weiteren Funktionselemente.

5. Verfahren nach mindestens einem der vorhergehenden Ansprüche, **dadurch gekennzeichnet, dass** beim Durchführen der Prüfung die ausgelesenen Elementinformationen des zweiten und/oder eines, mehrerer oder aller weiteren Funktionselemente berücksichtigt wird.

6. Verfahren nach mindestens einem der vorhergehenden Ansprüche, **dadurch gekennzeichnet, dass** die Angaben über die Art des Funktionselements umfassen, ob das jeweilige Funktionselement als Sensor, Aktor oder Apparaturkomponente ausgebildet ist, und/oder **dadurch gekennzeichnet, dass** die Angaben über die Art des Funktionselements eine Seriennummer des jeweiligen Funktionselements und/oder eine Artikelnummer des jeweiligen Funktionselements umfassen und/oder eine Typangabe des jeweiligen Funktionselements umfassen und/oder Angaben über die Herstellung des jeweiligen Funktionselements.

7. Verfahren nach mindestens einem der vorhergehenden Ansprüche, **dadurch gekennzeichnet, dass** die Angaben über die Funktion des Funktionselements umfassen
- Angaben über Betriebsparameter des jeweiligen Funktionselements, und/oder
- Angaben über Kompatibilitäten des jeweiligen Funktionselements mit anderen Funktionselementen, und/oder
- Angaben über die Verwendbarkeit des jeweiligen Funktionselements in verschiedenen Prozessen, und/oder
- Angaben über die Kalibrierung des jeweiligen Funktionselements, und/oder
- Angaben über die CE- und/oder UL-Kennzeichnung des jeweiligen Funktionselements, und/oder
- Angaben über die einzuhaltenden Service-Intervalle und/oder die maximale Betriebsdauer des jeweiligen Funktionselements.

8. Verfahren nach mindestens einem der vorhergehenden Ansprüche, **dadurch gekennzeichnet, dass** Informationen, die in der Steuereinheit gespeichert sind, umfassen
- Angaben über Kompatibilitäten von Funktionselementen, und/oder
- Angaben über die Verwendbarkeit von Funktionselementen in verschiedenen Prozessen, und/oder
- Angaben über durchzuführende Prozesse, wie Art und/oder Dauer des jeweiligen Prozesses, und/oder
- Angaben der in einem Prozess zu verwendenden Prozessparameter.

9. Verfahren nach mindestens einem der vorhergehenden Ansprüche, **dadurch gekennzeichnet, dass** die Prozessinformationen umfassen
- Angaben über einen durchgeführten Prozess, wie Art und/oder Dauer des Prozesses, und/oder
- Angaben der in einem Prozess verwendeten Prozessparameter, und/oder
- Angaben der Betriebsparameter, mit der das jeweilige Funktionselement und/oder weitere Funktionselemente in einem Prozess betrieben wurden, und/oder
- Angaben über zusammen mit dem jeweiligen Funktionselement verwendeten weiteren Funktionselemente, insbesondere deren Elementinformationen oder Teile davon, und/oder
- Angaben über Prozessergebnisse und/oder Prozessfehler.

10. Verfahren nach mindestens einem der vorhergehenden Ansprüche, **dadurch gekennzeichnet, dass** das Durchführen der Prüfung umfasst
- Vergleichen der Kompatibilitäten von Funktionselementen, insbesondere hinsichtlich deren gemeinsamer Verwendung und/oder deren Verwendbarkeit in einem geplanten Prozess und/oder deren Verwendbarkeit in einer geplanten Prozessumgebung, und/oder
**gekennzeichnet durch**
- Konfigurieren des ersten und/oder des zweiten und/oder eines oder mehrerer der weiteren Funktionselemente und/oder eines durchzuführenden Prozesses in Abhängigkeit der Prüfung, und/oder
- Speichern von Prozessinformationen in dem Speicher der Steuereinheit, und/oder
- Speichern von Prozessinformationen in einem Speicher einer Auswerteeinheit, und/oder
- Speichern von Serviceinformationen in dem Speicher des ersten und/oder des zweiten und/oder eines weiteren Funktionselements, und/oder
- Speichern von Kundeninformationen in dem Speicher des ersten und/oder des zweiten und/oder eines weiteren Funktionselements, und/oder
- Speichern von Elementinformationen.

11. Verfahren nach mindestens einem der vorhergehenden Ansprüche, **dadurch gekennzeichnet, dass** der Speicher des ersten und/oder des zweiten und/oder eines weiteren Funktionselements ein digitaler nichtflüchtiger Speicher ist, insbesondere ein EEPROM oder FRAM, beispielsweise ein One-Wire-EEPROM, und/oder **dadurch gekennzeichnet, dass** der Speicher des ersten und/oder des zweiten und/oder eines weiteren Funktionselements fluiddicht ausgebildet ist, und/oder
**dadurch gekennzeichnet, dass** der Speicher des ersten und/oder des zweiten und/oder eines weiteren Funktionselements sterilisierbar ist, vorzugsweise autoklavierbar und/oder strahlensterilisierbar, beispielsweise beta-sterilisierbar und/oder gamma-sterilisierbar, und/oder **dadurch gekennzeichnet, dass** der Speicher des ersten und/oder des zweiten und/oder eines weiteren Funktionselements eine Temperaturbeständigkeit von mindestens 100 Grad Celsius, vorzugsweise von mindestens 110 Grad Celsius, vorzugsweise von mindestens 120 Grad Celsius, vorzugsweise von mindestens 130 Grad Celsius, vorzugsweise von mindestens 150 Grad Celsius, aufweist.

12. Anwendung des Verfahrens nach mindestens einem der vorhergehenden Ansprüche in der Bioprozesstechnik und/oder in der Medizintechnik.

13. Vorrichtung zur Anwendung in der Bioprozesstechnik und/oder in der Medizintechnik,
umfassend
- ein erstes Funktionselement, das einen Speicher aufweist, in dem Elementinformationen gespeichert sind und die Elementinformationen Informationen über die Art und die Funktion des ersten Funktionselements umfassen,
- ein zweites Funktionselement, und
- eine Steuereinheit,
- wobei die Steuereinheit ausgebildet ist, die Elementinformationen aus dem ersten Funktionselement auszulesen und eine Prüfung der ausgelesenen Elementinformationen des ersten Funktionselements durchzuführen mit Elementinformationen, die von dem zweiten Funktionselement ausgelesen sind und/oder mit Informationen, die in der Steuereinheit gespeichert sind,
- wobei die Steuereinheit ausgebildet ist, mindestens eines des ersten und des zweiten Funktionselements in Abhängigkeit der Prüfung und/oder in Abhängigkeit der Elementinformationen zu steuern, und
- wobei die Steuereinheit ausgebildet ist, Prozessinformationen in dem Speicher des ersten Funktionselements zu speichern.

14. Verwendung einer Vorrichtung nach dem vorhergehenden Anspruch in der Bioprozesstechnik und/oder in der Medizintechnik.

15. Funktionselement für eine Vorrichtung zur Anwendung in der Bioprozesstechnik und/oder in der Medizintechnik nach dem vorhergehenden Anspruch und/oder für ein Verfahren nach mindestens einem der vorhergehenden Ansprüche 1-11, wobei das Funktionselement einen Speicher aufweist, in dem Elementinformationen gespeichert sind und die Elementinformationen Informationen über die Art und die Funktion des ersten Funktionselements umfassen, wobei das Funktionselement ausgebildet ist, von einer Steuereinheit gesteuert zu werden, und wobei der Speicher ausgebildet ist, von der Steuereinheit und/oder einer Auswerteeinheit ausgelesen zu werden, und wobei der Speicher ausgebildet ist, dass von der Steuereinheit und/oder einer Auswerteeinheit Prozessinformationen in dem Speicher speicherbar sind.
